# EUROPEAN PATENT APPLICATION

(11) **EP 3 460 572 A1**
(43) Date of publication of application: **27.03.2019**
(21) Application number: 17193045.6
(22) Date of filing: 26.09.2017
(51) Int. Cl.: G03F 1/72, G03F 1/76, G03F 1/42, G03F 9/00

(54) **PATTERNING DEVICE, MANUFACTURING METHOD FOR A PATTERNING DEVICE, SYSTEM FOR PATTERNING A RETICLE AND LITHOGRAPHIC APPARATUS**

(71) Applicant: ASML Netherlands B.V., 5500 AH Veldhoven (NL)
(72) Inventor: HOOGENBOOM, Thomas Leo Maria, 5500 AH Veldhoven (NL)
(74) Representative: Peters, John Antoine

(57) **Abstract**

A manufacturing method for a reticle is described, the manufacturing method comprising:
- providing a reticle to a first pattern generating tool;
- patterning the reticle with a first pattern;
- providing the reticle having the first pattern to a second pattern generating tool; and
- patterning the reticle with a second pattern configured to form a combined pattern with the first pattern, wherein the combined pattern has a different functionality than the first pattern.

## Description

### BACKGROUND

### Field of the Invention

The present invention relates to a manufacturing process for a patterning device, also referred to as a reticle, as can e.g. be applied in a lithographic projection apparatus.

### Description of the Related Art

A lithographic apparatus is a machine that applies a desired pattern onto a substrate, usually onto a target portion of the substrate. A lithographic apparatus can be used, for example, in the manufacture of integrated circuits (ICs). In such a case, a patterning device, which is alternatively referred to as a mask or a reticle, may be used to generate a circuit pattern, or part of a circuit pattern, that is to be formed on an individual layer of the IC. This pattern can be transferred onto a target portion (e.g. including part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Conventional lithographic apparatus include so-called steppers, in which each target portion is irradiated by exposing an entire pattern onto the target portion at once, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Patterning devices or reticles are typically manufactured by writing a desired pattern on a blank provided with a photoresist, e.g. using an electron beam (e-beam) or a laser. Such a process may take a substantial amount of time. In addition, once the patterning device or reticle has been manufactured, it may be difficult to make adjustments to the pattern.

### SUMMARY

It is desirable to provide a more flexible manufacturing method for patterning devices or reticles. According to an embodiment of the present invention, there is provided a manufacturing process for a reticle having a predetermined functionality, the manufacturing method comprising:
- obtaining a reticle having a first pattern, the first pattern representing a first functionality of an integrated circuit;
- patterning the reticle having the first pattern with a second pattern using a pattern generating tool, the combined first and second pattern having the predetermined functionality.

According to an embodiment of the present invention, there is provided a manufacturing method for a reticle, the manufacturing method comprising:
- providing a reticle to a first pattern generating tool;
- patterning the reticle with a first pattern;
- providing the reticle having the first pattern to a second pattern generating tool;
- patterning the reticle with a second pattern configured to form a combined pattern with the first pattern, wherein the combined pattern has a different functionality than the first pattern.

According to an embodiment of the invention, there is provided a system for patterning a reticle with a pattern, the system comprising:
- a first pattern generating tool configured to pattern the reticle with a first pattern;
- a second pattern generation tool for patterning the reticle with a second pattern, whereby the combined first and second pattern forms a pattern having a desired functionality.

According to a further embodiment of the invention, there is provided a lithographic apparatus comprising:
a pattern generation tool configured to:
   - receive a reticle having a first pattern, the first pattern representing a first functionality of an integrated circuit;
   - patterning the reticle with a second pattern configured to form a combined pattern with the first pattern, wherein the combined pattern has a predetermined functionality;
an illumination system configured to condition a radiation beam;
a support constructed to support the reticle, the reticle being capable of imparting the radiation beam with a pattern in its cross-section to form a patterned radiation beam;
a substrate table constructed to hold a substrate; and
a projection system configured to project the patterned radiation beam onto a target portion of the substrate.

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 schematically depicts a patterning device including a patterned area.
- Figure 3 schematically depicts a flow-chart of a manufacturing method according to the present invention;
- Figures 4 and 5 schematically depict patterning devices, according to the present invention, as can be obtained using a method according to the present invention.
- Figure 6 schematically depicts the patterning of a feature in two distinct patterning steps.

### DETAILED DESCRIPTION

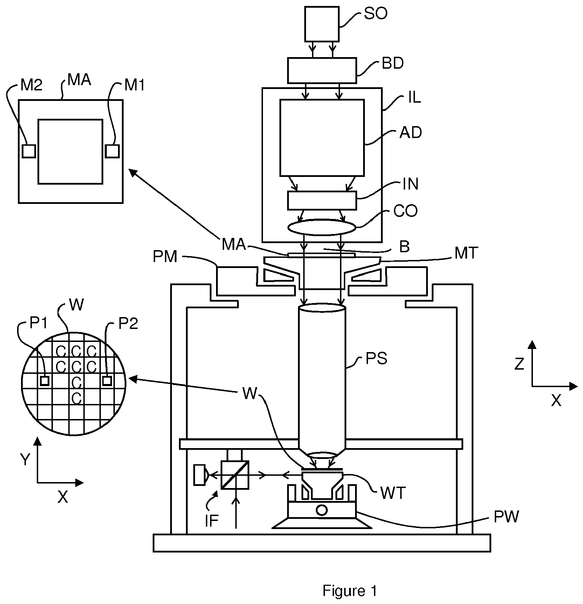

Figure 1 schematically depicts a lithographic apparatus according to one embodiment of the invention. The apparatus includes an illumination system (illuminator) IL configured to condition a radiation beam B (e.g. UV radiation or any other suitable radiation), a mask support structure (e.g. a mask table) MT constructed to support a patterning device (e.g. a mask) MA and connected to a first positioning device PM configured to accurately position the patterning device in accordance to certain parameters. The apparatus also includes a substrate table (e.g. a wafer table) WT or "substrate support" constructed to hold a substrate (e.g. a resist-coated wafer) W and connected to a second positioning device PW configured to accurately position the substrate in accordance with certain parameters. The apparatus further includes a projection system (e.g. a refractive projection lens system) PS configured to project a pattern imparted to the radiation beam B by patterning device MA onto a target portion C (e.g. including one or more dies, or a part of one or more dies) of the substrate W.

The illumination system may include various types of optical components, such as refractive, reflective, magnetic, electromagnetic, electrostatic or other types of optical components, or any combination thereof, for directing, shaping, or controlling radiation.

The mask support structure supports, i.e. bears the weight of, the patterning device. In an embodiment, the patterning device can e.g. a patterning device according to the present invention. It holds the patterning device in a manner that depends on the orientation of the patterning device, the design of the lithographic apparatus, and other conditions, such as for example whether or not the patterning device is held in a vacuum environment. The mask support structure can use mechanical, vacuum, electrostatic or other clamping techniques to hold the patterning device. The mask support structure may be a frame or a table, for example, which may be fixed or movable as required. The mask support structure may ensure that the patterning device is at a desired position, for example with respect to the projection system. Any use of the terms "reticle" or "mask" herein may be considered synonymous with the more general term "patterning device".

The term "patterning device" used herein should be broadly interpreted as referring to any device that can be used to impart a radiation beam with a pattern in its cross-section so as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Masks are well known in lithography, and include mask types such as binary, alternating phase-shift, and attenuated phase-shift, as well as various hybrid mask types. Patterning devices that are transmissive may e.g. be used in combination with an illumination system IL that applies a UV or DUV radiation source (e.g. having a wavelength of or about 365, 248, 193, 157 or 126 nm). Patterning devices that are reflective may e.g. be used in combination with an illumination system that applies an EUV radiation source, e.g. having a wavelength of about 10-13 nm.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a reflective mask).

The lithographic apparatus may be of a type having two (dual stage) or more substrate tables or "substrate supports" (and/or two or more mask tables or "mask supports"). In such "multiple stage" machines the additional tables or supports may be used in parallel, or preparatory steps may be carried out on one or more tables or supports while one or more other tables or supports are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques can be used to increase the numerical aperture of projection systems. The term "immersion" as used herein does not mean that a structure, such as a substrate, must be submerged in liquid, but rather only means that a liquid is located between the projection system and the substrate during exposure.

Referring to figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD configured to adjust the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the mask support structure (e.g., mask table MT), and is patterned by the patterning device. Having traversed the mask MA, the radiation beam B passes through the projection system PS, which focuses the beam onto a target portion C of the substrate W. With the aid of the second positioning device PW and position sensor IF (e.g. an interferometric device, linear encoder or capacitive sensor), the substrate table WT can be moved accurately, e.g. so as to position different target portions C in the path of the radiation beam B. Similarly, the first positioning device PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioning device PM. Similarly, movement of the substrate table WT or "substrate support" may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT or "mask support" and the substrate table WT or "substrate support" are kept essentially stationary, while an entire pattern imparted to the radiation beam is projected onto a target portion C at one time (i.e. a single static exposure). The substrate table WT or "substrate support" is then shifted in the X and/or Y direction so that a different target portion C can be exposed. In step mode, the maximum size of the exposure field limits the size of the target portion C imaged in a single static exposure.
2. In scan mode, the mask table MT or "mask support" and the substrate table WT or "substrate support" are scanned synchronously while a pattern imparted to the radiation beam is projected onto a target portion C (i.e. a single dynamic exposure). The velocity and direction of the substrate table WT or "substrate support" relative to the mask table MT or "mask support" may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

Combinations and/or variations on the above described modes of use or entirely different modes of use may also be employed.

According to an aspect of the present invention, there is provided a manufacturing method for a reticle for use in a lithographic apparatus. A reticle or patterning device as used in a lithographic apparatus typically has a rectangular shape and comprises an area that is patterned, i.e. provided with a pattern.

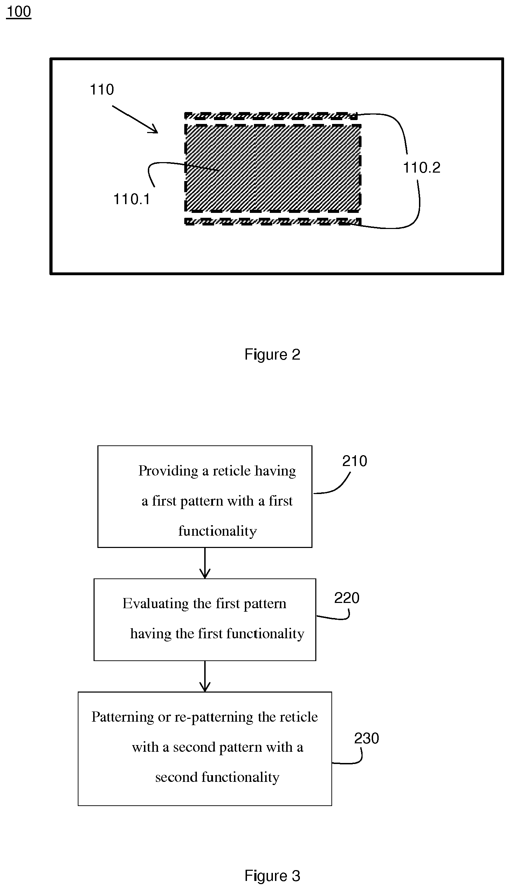

Figure 2 schematically shows a top view of a reticle 100 including a pattered area 110. In the arrangement as shown, the patterned area 110 includes a pattern 110.1 that is to be imparted to the radiation beam applied so as to form, during an exposure process, a pattern on a substrate. The pattern as formed on the substrate will serve to manufacture part of an integrated circuit (IC) on the substrate. The pattern 110.1 is further on also referred to as the IC-pattern. The patterned area 110 also includes a border or border area 110.2 in which a plurality of different types of marks may be provided, e.g. including alignment marks, overlay marks, metrology marks; these may e.g. facilitate assessing the accuracy of the projection and exposure process and/or may facilitate the projection or exposure process itself. The pattern or patterns in the border area will typically not be part of the exposed pattern forming the integrated circuit on the substrate. Note that marks for facilitating the exposure process, such as alignment marks, or marks for evaluating the accuracy of the exposure process, such as overlay marks, may also be provided along other sides of the pattern 110.1. Alternatively, or in addition, such markings may also be provided in internal scribe lanes, e.g. inside the 110.1 pattern.

Such a reticle 100 may be manufactured by a number of techniques, e.g. depending on the method of writing a pattern onto the reticle. Typically, an e-beam or a laser are currently applied for writing a pattern onto a reticle. The process of manufacturing a reticle including a pattern may e.g. comprise the following steps:
- providing a glass or quartz plate;
- depositing a Cr-layer or the like on the glass or quartz plate;
- depositing an anti-reflective coating (ARC) on the Cr-layer;
- applying a photoresist layer on the ARC;
- direct writing a desired pattern on the photoresist layer;
- developing the pattern in the photoresist layer;
- etching the pattern into the Cr-layer and
- removing the photoresist layer.

In case the reticle is to be used with an EUV-type radiation beam, the manufacturing process may e.g. include the following steps:
- providing a low thermal expansion (LTE) substrate;
- depositing a multilayer stack on the substrate;
- depositing a capping layer on the multilayer stack and a buffer layer on the capping layer;
- depositing an absorber layer on the buffer layer;
- applying a photoresist layer on the absorber layer;
- direct writing a desired pattern on the photoresist layer;
- developing the pattern in the photoresist layer;
- etching the pattern into the absorber layer and
- removing the photoresist layer.

Using these processes, a patterning device 100 having a pattern 110 as schematically shown in Figure 2 may be generated.

Typically, from then on, the functionality of the pattern 110 will not be altered; the desired pattern, having a predetermined desired functionality, will typically be written on the photoresist in one process step, e.g. a direct writing step.

It is believed that this approach poses some drawbacks and may be improved. The alternative manner of manufacturing a patterning device that is proposed in an embodiment of the present invention involves the manufacturing of a patterning device such as a reticle in two distinct patterning steps to arrive at a desired pattern.

The use of two distinct patterning steps significantly increases the flexibility with which a pattern can be generated, and offers the possibility to arrive, in an efficient way, at a desired pattern. Such a flexibility may e.g. enable the exposure of a lot of substrates with a particular pattern, or even the exposure of a single substrate with a particular pattern. In an embodiment of the present invention, the manufacturing process of a reticle thus enables to modify a desired pattern on a per lot basis, on a per substrate basis, or even on a per die basis. As an example of the latter, the present invention can e.g. be used to inscribe a unique digital code or signature in each IC that is manufactured, e.g. enabling each IC to be traced. This may e.g. be useful to trace the origin of air-bag ignition chip failures.

Embodiments of the present invention may e.g. include manufacturing processes whereby different tool or different types of tools may be applied to perform the two distinct patterning steps. Embodiments of the present invention may also include manufacturing processes whereby an evaluation step is performed in between the two distinct patterning steps. As an example of such an evaluation step, a process set-up of a lithographic apparatus, during which the patterning device having the first pattern is used, can be mentioned. The purpose of such a process set-up can be understood as follows:
The objective or purpose of a reticle is to impart a radiation beam with a pattern that needs to be aligned with a target area on a substrate, e.g. an area comprising a previously exposed pattern or a plurality of previously exposed patterns. In order to obtain an accurate transfer of the patterned radiation beam, the various components of the lithographic apparatus may need to be configured, calibrated or tuned to arrive at the best possible transfer of the pattern. This process of adjusting the lithographic apparatus may e.g. be referred to as a process to set-up the apparatus.
During such a set-up of the apparatus, one may occasionally encounter the situation that certain patterns or portions of patterns are not optimal, given the particular set-up of the lithographic apparatus.
In particular, it is worth mentioning that the patterning of a properly set-up lithographic apparatus may still be non-optimal:
- The lithographic apparatus may drift over time; either in a predictable way or in a way that can be measured and therefore compensated for in a feedback loop.
- The substrate that is being patterned may change shape; either in a predictable way (e.g. because of heating effects), or in a way that can be measured, e.g. just before or during patterning. Such expected substrate shape variations can e.g. be compensated by adapting the patterning process, e.g. by adapting the pattering device.
- The patterning device or reticle itself may be subject to drift in any of its properties, just because of time, or because it is being used for patterning (e.g. due to heating effects). If these changes are predictable, or can be modeled based on measurements, they can be compensated for.
- The lithographic apparatus is also used to compensate for patterning imperfections that have developed on a substrate due to prior process steps, or that are predicted to occur in later process steps. Since the steps and apparatus used for substrate patterning are not necessarily the same for every substrate, even if the substrates are manufactured to essentially the same design, the compensation referred to above can also be different for each substrate being patterned.
As such, during the set-up of the lithographic apparatus, it may become clear that certain properties of marks or markings as applied on the reticle, e.g. alignment marks or overlay marks provided in the border or border area 110.2 of the pattern 110, are not ideal.

When such an assessment is made, the manufacturing process according to an embodiment of the present invention enables, by means of performing a second patterning step, to obtain a patterning device having the desired pattern, e.g. including marks having the desired dimensions. As another example, by means of performing a second patterning step, a changed or augmented pattern may be obtained, the pattern being changed or augmented in one of its physical dimensions, including but not restricted to size, shape, index of refraction, coefficient of extension, physical composition, etc., such that the desired changes in the patterning of a substrate are achieved.

More explicitly, the manufacturing process according to this embodiment may thus comprises the steps of:
- obtaining a substrate having a first pattern, the first pattern representing a first functionality;
- performing a process set up of a lithographic apparatus using the substrate;
- determining a desired characteristic of the patterning device, e.g. based on the process set up, or on an expected drift characteristic or a required correction or compensation of patterning imperfections of previous process steps;
- determining the second pattern based on desired characteristic.
- patterning the substrate having the first pattern with a second pattern using a pattern generating tool, the combined first and second pattern having the desired functionality.

In such embodiment, the first pattern may e.g. comprise a first portion representative of the pattern that is to be projected into a resist layer of a substrate, this pattern having a particular functionality in the integrated circuit that is manufactured, and a second portion, e.g. comprising a plurality of alignment marks having different dimensions and/or pitches. This second portion thus having a particular functionality with respect to facilitating or assessing the exposure process.
A reticle having such a first pattern may e.g. be used in process set-up of a lithographic apparatus, during which set-up, it becomes apparent that a particular alignment mark of the plurality of alignment marks provided on the second portion enables the most accurate alignment.
In such case, the second pattern that is patterned onto the reticle may e.g. comprise a plurality of said particular alignment marks so as to arrive at a reticle comprising a reticle having a plurality of optimal alignment marks. Depending on the circumstances, it may also be possible that the second pattern results in a modification of some of the alignment marks, thereby resulting in marks having the optimal properties. The application of the second pattern could therefore also be described as a re-pattering step.
Figure 3 schematically illustrates the above described process. The manufacturing process according to an embodiment of the present invention as illustrated in Figure 3 comprises a first step 210 of providing a substrate having a first pattern with a first functionality. Subsequently, the process comprises the step 220 of evaluating the first pattern. Such an evaluation may e.g. take place during a process set up of a lithographic apparatus that will use the reticle. Based on the outcome of the evaluation, the manufacturing process then comprises a third step 230 of patterning or re-pattering at least part of the reticle with a second pattern, the second pattern having a second functionality, different from the first functionality.

The manufacturing method according to the present invention, which provides in a method of manufacturing a patterning device in two distinct patterning steps to arrive at a desired pattern may further advantageously be applied in other circumstances that illustrated above.

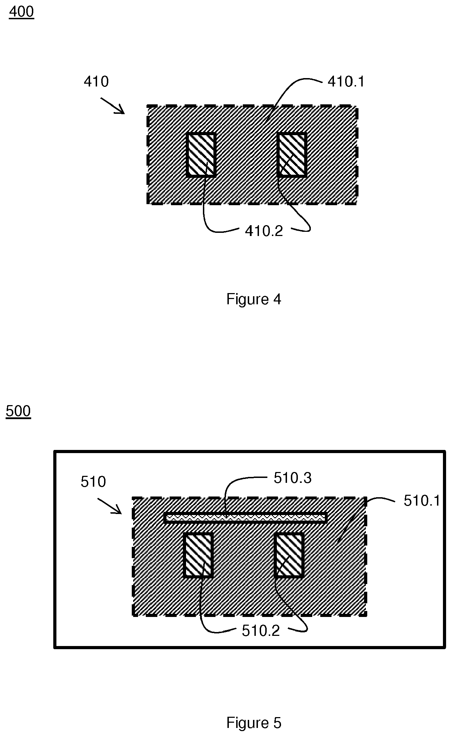

As a next example of a manufacturing method according to the present invention whereby two distinct patterning steps are applied, a method is discussed whereby the IC-pattern 110.1 of a desired pattern on a reticle is considered to be subdivided into two patterns, whereby each of those patterns is patterned separately in a distinct patterning step; the sequential performing of the distinct patterning steps resulting in the desired IC-pattern. In such embodiment, a purposive subdivision of a desired pattern, such as IC-pattern 110.1 shown in Figure 2 is made beforehand. Figure 4 schematically illustrates a patterning device or reticle 400 having a pattern 410 that is to be imparted to a radiation beam applied so as to form, during an exposure process, a pattern on a substrate; said pattern subsequently being used to manufacture a part of an integrated circuit (IC). As shown, the pattern 410 is subdivided into a first pattern 410.1 and a second pattern 410.2. In the embodiment as shown, the second pattern 410.2 form only a comparatively small portion of the combined desired pattern 410, i.e. the combined pattern having a desired functionality. In an embodiment, the second pattern may e.g. cover less than 10% of the desired pattern 410, e.g. less than 5% or only a few % of the area of the desired pattern 410. In accordance with an embodiment of the present invention, the desired pattern 410 may be patterned onto the patterning device by performing the steps of:
- providing the reticle onto which the pattern 410 is to be provided to a first pattern generating tool and patterning the reticle with the first pattern 410.1 by the first pattern generating tool;
- providing the reticle having the first pattern to a second pattern generating tool;
- patterning the reticle with the second pattern 410.2 so as to arrive at a combined pattern comprising the first and second pattern 410.1, 410.2, the combined pattern having the desired functionality.

As will be clear to the skilled person, by subdividing the desired pattern 410 into two patterns 410.1, 410.2, neither one of these patterns, taken alone, will have the desired functionality of the combined pattern 410. Only when both patterns have been applied to the reticle, the desired functionality will be realized.

It has been devised by the inventors that there may be various reasons for subdividing a pattern such as an IC-pattern 110.1 or 410 into two pattern 410.1, 410.2 who, when combined, form a desired pattern.

In accordance with an embodiment of the present invention, a subdivision of a desired pattern or desired IC-pattern is based on a distribution of the pattern density of the pattern. In such embodiment, portions of the desired pattern having a low pattern density may be grouped so as to form a first pattern, whereas portions of the desired pattern having a high pattern density may be grouped so as to form a second pattern.
Within the meaning of the present invention, pattern density may be considered a measure to indicate the number or amount of distinct features per unit area. As such, areas having comparatively large or coarse features may be considered areas having a comparatively low pattern density, whereas areas have comparatively small, fine features may be considered areas having a comparatively high pattern density. In case such a subdivision is made, one may subsequently select which tools would be most suited for patterning the respective first pattern 410.1 and second pattern 410.2. It may e.g. be feasible to pattern the first pattern, e.g. the pattern comprising the comparatively coarse or large features, with a patterning tool that would be unsuited to pattern areas with a high pattern density. At the same time, it would be inefficient to use a tool that is suited to pattern patterns with a high pattern density for the patterning of large or coarse features.
It can be noted that the subdivision into a first pattern having coarse features and a second pattern having fine features does not require that both patterns need to occupy distinct areas as indicated in Figure 4.
Both patterns may be interleaved or intertwined. In fact, one may even, on a feature by feature basis, determine whether or not a feature belongs to the first pattern, e.g. to be patterned by a first patterning tool or belongs to the second pattern, e.g. to be patterned by a second patterning tool. As an example of such a subdivision, the first pattern may e.g. consist of the main features that characterize the pattern as is should be patterned onto a substrate, whereas the second pattern e.g. consists of assist features to ensure the proper projection of the main features onto the substrate.
In another embodiment of the present invention, the subdivision of a desired IC pattern is based on the required functionality rather than on the feature or pattern density. In particular, the present invention enables an efficient manner to customize a reticle pattern; in an embodiment of the present invention, the pattern that is to be provided on the reticle is subdivided into a first pattern, referred to as a basic or generic IC pattern, and a second pattern, referred to as a specific or customer specific pattern. It may occur that a foundry, i.e. a chip or IC manufacturer, wishes to pattern different devices or layers forming parts of devices, whereby the applied pattern of the different devices or layers share a common design. It may even occur that the desired pattern for the different devices or layer is identical, apart from some or a few details. As an example, the detailed wiring of an FPGA array may be consider a detail, different from the common FPGA design. When such a subdivision is made, one may, in a first patterning step of a manufacturing process according to an embodiment of the present invention, prepare a plurality of reticles by providing them with the first pattern. Subsequently, when a customer order a particular reticle, one may complete the pattern on the reticle by a second patterning step whereby a second pattern, as specified by the customer, is applied. As an example of such a specific or customer specific pattern, a pattern defining a position or positions of contact holes may be mentioned. In such an embodiment, the first pattern may comprise a plurality of possible positions of such contact holes, whereby the second pattern, based on a customer specification, provided in the actual contact hole pattern. Since the reticle with the first, basic or generic, pattern is already available, the manufacturing process from order to delivery of the customized reticle can be shortened. In addition, the manufacturing costs for such a customized reticle may be reduced.
As such, in an embodiment of the present invention, the second patterning step, which can also be referred to as a re-patterning step, could include applying modifications to any of the features that are patterned by the first patterning step. Such modifications can be made to any feature (coarse or fine), patterned during the first patterning step. In this respect, it can be noted that small changes at reticle level can create big changes in the patterning of the substrate - an effect that can be exploited to reduce the percentage of the patterning device that needs to be patterned. As such, in an embodiment, the re-patterning of the patterning device may e.g. be limited to the modification of only a few features on the patterning device. Even a modification on only a limited number of features by means of the second patterning step may lead to larger-scale (but controlled) changes in the pattern exposed on the substrate.

In an embodiment of the present invention, the aforementioned methods of:
- subdividing a desired pattern into a pattern having a comparatively high pattern density and a pattern having a comparatively low pattern density, and
- subdividing a desired pattern into a basis or generic pattern and a specific or customer specific pattern, may be combined.
Figure 5 schematically shows an embodiment of a reticle or patterning device 500 in which both subdivisions are combined.
The reticle 500 as shown in Figure 5 comprises a pattern 510, whereby the pattern 510 comprises three different patterns 510.1, 510.2 and 510.3.
In an embodiment, the combined patterns 510.1 and 510.2 may e.g. form a basic or generic pattern, whereas the pattern 510.3 may from a specific or customer specific pattern.
Further, in the embodiment as illustrated, pattern 510.1 may e.g. have a comparatively low pattern density while the pattern 510.2 may e.g. have a comparatively high pattern density.

When such a subdivision of the pattern 510 is made, the pattern may e.g. be manufactured in the following manner:
- providing the reticle onto which the pattern 510 is to be provided to a first pattern generating tool and patterning the reticle with the first pattern 510.1 by the first pattern generating tool;
- providing the reticle having the first pattern to a second pattern generating tool;
- patterning the reticle with the second pattern 510.2 so as to arrive at a combined pattern comprising the first and second pattern 510.1, 510.2, the combined pattern forming the basis or generic pattern of the reticle 510;
- patterning the reticle with the third pattern 510.3, the third pattern 510.3 e.g. being based on a user specification.

In an embodiment of the present invention, the pattern as applied in the second patterning step is a volatile or removable pattern. Within the meaning of the present invention, a volatile or removable pattern refers to a pattern that either gradually disappears, e.g. by evaporation or which can be easily removed, e.g. using plasma-cleaning using radicals.

Patterns that possess such a property, i.e. pattern that are volatile or easily removable may e.g. be provided on the reticle using an electron beam induced deposition (EBID) tool. Electron beam-induced deposition (EBID) is a high-resolution direct write lithography technique that is capable of writing nanometer-scale patterns. In such a tool, an electron beam is focused onto a sample in a scanning electron microscope (SEM) and made to react with a gas, referred to as the precursor gas that is let into the SEM through a nozzle that is positioned near the reticle that is to be patterned. Due to the interaction with the e-beam, the gas molecules are dissociated into a volatile part, which can be removed out of the SEM, and a nonvolatile part, which remains on the reticle surface, forming a deposit. Typical precursors are W(CO)₆ and trimethyl (methylcyclopentadienyl)-platinum (IV) (MeCpPtMe₃), which lead to tungsten and platinum deposits, respectively. By appropriate selection of the precursor gas, a deposit can be obtained which is volatile or is easily removable, e.g. by means of plasma-cleaning using radicals.

The manufacturing method according to the present invention, which includes two distinct patterning steps to arrive at a patterning device with a desired pattern, can as discussed above, be used in various circumstances and for various purposes.

One of the merits of the present invention, is that it enables to incorporate the use of a patterning tool with limited patterning speed in the manufacturing process of patterning devices without substantially affecting the manufacturing time. The patterning tool with limited patterning speed may e.g. be applied to only pattern a comparatively small portion of the desired pattern, e.g. to adjust a previously applied first pattern. Such a comparatively small portion may e.g. represent a customer specific portion of the pattern.

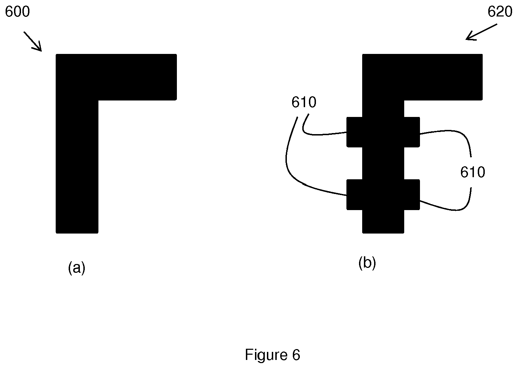

Figure 6 schematically shows an example of a feature 600 as e.g. provided on a patterning device using a first patterning step (a). Using a second patterning step, the feature 600 may be complemented with a second pattern including features 610, to arrived at a desired combined pattern or feature 620.

Examples may e.g. include:
- A variation of the circuit pattern (e.g. to inscribe a unique code or induce a variation of the device function);
- An adjustment of the registration between this pattern and a previous pattern on the wafer (overlay adjustment);
- An adjustment of dose, focus, CD or other patterning parameter, relevant to maximize certain key pattern parameters of the pattern on the substrate;
- An adjustment of the patterning of marks, present on the patterning device, to effect a correction of overlay, focus, CD or other patterning parameter, when the mask is aligned in the lithographic apparatus prior to use.

In an embodiment of the present invention, an EBID tool is applied for providing the second patterning step. Because the EBID tool includes a SEM, it also offers to possibility to accurately assess the quality of the applied second patterning step. Further, an accurate assessment of critical features of the first patterning step can be performed as well.

In an embodiment, an e-beam lithography tool is applied for providing the first patterning step. Alternatively, in case of comparatively coarse features are to be patterned, the first patterning step can be made using an optical pattern generator or a plotter.

As illustrated above, the reticle manufacturing method according to the present invention, whereby a pattern to be provided on the reticle is patterned onto the reticle in at least two distinct patterning steps, enables a more effective and efficient use of available patterning tools. The method also enables to anticipate on a wish to customize the pattern on a reticle. By subdividing the desired pattern in the manner as discussed, an increased flexibility can be obtained with respect to customising mask patterns and a reduced manufacturing time. Overall costs for generating a mask with a particular pattern may be reduced as well.

It should be pointed out that the two step generation of the desired pattern according to the present invention is unrelated to the application of amendments made to generated patterns in order to fix defects in the patterns. It is acknowledged that the repair of defects of reticles can e.g. be performed using e-beam tool. However, the processes as performed by these tool do not enhance or modify the functionality of the pattern.

In an embodiment, the present invention provides a reticle for us in a lithographic apparatus, the reticle being manufactured according to the manufacturing method according to the invention. In an embodiment, the reticle manufacture is a reticle for use in an EUV lithographic apparatus. The reticle as manufactured may also be a reticle for use in a DUV lithographic apparatus. In an embodiment, the present invention provides in a system for providing a predetermined pattern on a reticle. In an embodiment, such a system comprises a first patterning tool configured to pattern a reticle, e.g. a reticle blank, with a first pattern. The system may further comprises a second pattern generation tool for patterning the reticle with a second pattern, whereby the combined first and second pattern results in a pattern having a desired functionality.

Alternatively, the system may comprise a pattern generation tool configured to sequentially apply the first and second pattern. In such embodiment, the system may e.g. be configured to output the reticle provided with the first pattern for evaluation during a process set up in a lithographic apparatus. Based on the outcome of the evaluation, requirements for the second pattern may be determined, the actual required layout of the second pattern may be determined and the reticle may be supplied back to the system for being patterned with the second pattern.

In an embodiment, the present invention provides in a lithographic apparatus that comprises a pattern generation tool. In an embodiment, the pattern generation tool is configured to:
- receive a reticle having a first pattern, the first pattern representing a first functionality of an integrated circuit; and
- pattern the reticle having the first pattern with a second pattern the combined first and second pattern having a predetermined functionality.
As such, in an embodiment of the present invention, a lithographic apparatus is provided which is capable of receiving a reticle which has a pattern on it, e.g. a basic or generic circuit design, and which is capable or adjusting or completing the pattern by patterning a second pattern on it, e.g. based on a customer requirement. Such a lithographic apparatus mag e.g. further comprise:
an illumination system configured to condition a radiation beam;
a support constructed to support the reticle, the reticle being capable of imparting the radiation beam with a pattern in its cross-section to form a patterned radiation beam;
a substrate table constructed to hold a substrate; and
a projection system configured to project the patterned radiation beam onto a target portion of the substrate.

In an embodiment, the pattern generation tool as provided in the lithographic apparatus according to the present invention is an EBID tool, as discussed above.

Further embodiments of the invention are disclosed in the list of numbered embodiments below:
1. Manufacturing process for a reticle having a predetermined functionality, the manufacturing method comprising:
   - obtaining a reticle having a first pattern, the first pattern representing a first functionality of an integrated circuit;
   - patterning the reticle having the first pattern with a second pattern using a pattern generating tool, the combined first and second pattern having the predetermined functionality.
2. Manufacturing process according to embodiment 1, wherein the step of patterning the reticle having the first pattern with a second pattern is preceded by:
   - performing a process set up of a lithographic apparatus using the reticle;
   - determining a desired characteristic of the reticle, based on the process set up;
   - determining the second pattern based on desired characteristic.
3. Manufacturing process according to embodiment 2, wherein the desired characteristic comprises a dimension of a mark on the reticle, and wherein the second pattern comprises one or more marks having the dimension.
4. Manufacturing method for a reticle, the manufacturing method comprising:
   - providing a reticle to a first pattern generating tool;
   - patterning the reticle with a first pattern;
   - providing the reticle having the first pattern to a second pattern generating tool;
   - patterning the reticle with a second pattern configured to form a combined pattern with the first pattern, wherein the combined pattern has a different functionality than the first pattern.
5. Manufacturing method according to embodiment 4, further comprising:
   - providing a further reticle onto which a pattern is to be provided to the first pattern generating tool;
   - patterning the further reticle with the first pattern;
   - providing the further reticle having the first pattern to the second pattern generating tool;
   - patterning the further reticle with a third pattern; a further combined pattern comprising the first and third pattern having a different functionality than the first pattern and than the combined pattern.
6. The manufacturing method according to embodiment 4, wherein the first pattern represents a basic circuit pattern.
7. The manufacturing method according to embodiment 4 or 5, wherein the second pattern represents a customer specific pattern or a customer specific modification of the first pattern.
8. The manufacturing method according to embodiment 5, wherein the third pattern represents a further customer specific pattern.
9. The manufacturing method according to embodiment 4, wherein the first pattern generating tool comprises an e-beam exposure system.
10. The manufacturing method according to embodiment 4, wherein the second pattern generating tool comprises an e-beam induced deposition tool.
11. The manufacturing method according to embodiment 1, wherein the first pattern comprises a plurality of alignment marks having different dimensions and wherein the second pattern comprises a plurality of alignment marks having the same dimensions.
12. The manufacturing method according to embodiment 4, wherein the second pattern is a volatile pattern.
13. The manufacturing method according to embodiment 4, wherein the second pattern is removable.
14. The manufacturing method according to embodiment 13, wherein the second pattern is removable by means of plasma cleaning using radicals.
15. A reticle manufactured according to the manufacturing process according to any of the preceding embodiments.
16. The reticle according to embodiment 15, wherein the reticle is suited for EUV lithography.
17. The reticle according to embodiment 15, wherein the reticle is suited for DUV lithography.
18. A system configured to perform the manufacturing process according to any of the embodiments 1 to 14.
19. A system for patterning a reticle with a pattern, the system comprising:
   - a first pattern generating tool configured to pattern the reticle with a first pattern;
   - a second pattern generation tool for patterning the reticle with a second pattern, whereby the combined first and second pattern forms a pattern having a desired functionality.
20. A lithographic apparatus comprising:
   a pattern generation tool configured to:
      - receive a reticle having a first pattern, the first pattern representing a first functionality of an integrated circuit;
      - patterning the reticle with a second pattern configured to form a combined pattern with the first pattern, wherein the combined pattern has a predetermined functionality;
   an illumination system configured to condition a radiation beam;
   a support constructed to support the reticle, the reticle being capable of imparting the radiation beam with a pattern in its cross-section to form a patterned radiation beam; a substrate table constructed to hold a substrate; and
   a projection system configured to project the patterned radiation beam onto a target portion of the substrate.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. Manufacturing process for a reticle having a predetermined functionality, the manufacturing method comprising:
- obtaining a reticle having a first pattern, the first pattern representing a first functionality of an integrated circuit;
- patterning the reticle having the first pattern with a second pattern using a pattern generating tool, the combined first and second pattern having the predetermined functionality.

2. Manufacturing process according to claim 1, wherein the step of patterning the reticle having the first pattern with a second pattern is preceded by:
- performing a process set up of a lithographic apparatus using the reticle;
- determining a desired characteristic of the reticle, based on the process set up;
- determining the second pattern based on desired characteristic.

3. Manufacturing process according to claim 2, wherein the desired characteristic comprises a dimension of a mark on the reticle, and wherein the second pattern comprises one or more marks having the dimension.

4. Manufacturing method for a reticle, the manufacturing method comprising:
- providing a reticle to a first pattern generating tool;
- patterning the reticle with a first pattern;
- providing the reticle having the first pattern to a second pattern generating tool;
- patterning the reticle with a second pattern configured to form a combined pattern with the first pattern, wherein the combined pattern has a different functionality than the first pattern.

5. Manufacturing method according to claim 4, further comprising:
- providing a further reticle onto which a pattern is to be provided to the first pattern generating tool;
- patterning the further reticle with the first pattern;
- providing the further reticle having the first pattern to the second pattern generating tool;
- patterning the further reticle with a third pattern; a further combined pattern comprising the first and third pattern having a different functionality than the first pattern and than the combined pattern.

6. The manufacturing method according to claim 4, wherein the first pattern represents a basic circuit pattern.

7. The manufacturing method according to claim 4 or 5, wherein the second pattern represents a customer specific pattern or a customer specific modification of the first pattern.

8. The manufacturing method according to claim 5, wherein the third pattern represents a further customer specific pattern.

9. The manufacturing method according to claim 4, wherein the second pattern generating tool comprises an e-beam induced deposition tool.

10. The manufacturing method according to claim 1, wherein the first pattern comprises a plurality of alignment marks having different dimensions and wherein the second pattern comprises a plurality of alignment marks having the same dimensions.

11. The manufacturing method according to claim 4, wherein the second pattern is a volatile pattern.

12. The manufacturing method according to claim 4, wherein the second pattern is removable.

13. A reticle manufactured according to the manufacturing process according to any of the preceding claims.

14. A system for patterning a reticle with a pattern, the system comprising:
- a first pattern generating tool configured to pattern the reticle with a first pattern;
- a second pattern generation tool for patterning the reticle with a second pattern, whereby the combined first and second pattern forms a pattern having a desired functionality.

15. A lithographic apparatus comprising:
a pattern generation tool configured to:
- receive a reticle having a first pattern, the first pattern representing a first functionality of an integrated circuit;
- patterning the reticle with a second pattern configured to form a combined pattern with the first pattern, wherein the combined pattern has a predetermined functionality;
an illumination system configured to condition a radiation beam;
a support constructed to support the reticle, the reticle being capable of imparting the radiation beam with a pattern in its cross-section to form a patterned radiation beam;
a substrate table constructed to hold a substrate; and
a projection system configured to project the patterned radiation beam onto a target portion of the substrate.
